(19) Europäisches Patentamt
European Patent Office
Office européen des brevets

(11) Publication number: 0 415 422 A2

(12) **EUROPEAN PATENT APPLICATION**

(21) Application number: 90116678.5

(51) Int. Cl.[5]: G03F 7/021

(22) Date of filing: 30.08.90

(30) Priority: 31.08.89 JP 225596/89
31.08.89 JP 225597/89

(43) Date of publication of application:
06.03.91 Bulletin 91/10

(84) Designated Contracting States:
DE GB

(71) Applicant: FUJI PHOTO FILM CO., LTD.
No. 210, Nakanuma Minami-Ashigara-shi
Kanagawa-ken(JP)

(72) Inventor: Kamiya, Akihiko, c/o Fuji Photo Film Co., Ltd.
4000, Kawashiri, Yoshida-cho
Haibara-gun, Shizuoka-ken(JP)

(74) Representative: Patentanwälte Grünecker, Kinkeldey, Stockmair & Partner
Maximilianstrasse 58
W-8000 München 22(DE)

(54) **Method for forming images.**

(57) A method for forming images which comprises the steps of, in order, imagewise exposing to light a light-sensitive material comprising a support having thereon a light-sensitive layer containing a light-sensitive co-condensed diazo resin having a structural unit derived from an aromatic compound having at least one of carboxyl and hydroxyl groups and a structural unit derived from an aromatic diazonium compound to form light-exposed and light-unexposed areas in the light-sensitive layer, and developing the light-sensitive material with an aqueous alkaline developer substantially free from an organic solvent to remove the light-exposed areas of the light-sensitive layer. The method makes it possible to solve the problems concerining hygiene such as toxicity and giving out of bad smell during operations, those concerning safety such as catching a fire and a gas explosion, those concerning workability such a foaming and environmental pollution by exhaust liquid. The method further makes it possible to minimize the cost.

EP 0 415 422 A2

# METHOD FOR FORMING IMAGES

## BACKGROUND OF THE INVENTION

The present invention relates to a method for forming images which is favorably used in the formation of a lithographic printing plate, integrated circuits and photomasks.

A lithographic printing plate can in general be prepared by applying a light-sensitive composition onto a substrate such as an aluminum plate, irradiating the resulting light-sensitive layer with actinic rays such as ultraviolet rays through e.g. a negative transparency to polymerize or crosslink the portions which have been irradiated with the actinic rays, to thus make the portions insoluble in a developer and developing the light-sensitive layer with the developer to remove the non-irradiated portions. In this case, the irradiated and non-irradiated portions serve as image parts which repel water and receive an oily ink and non-image parts which receive water and repel an oily ink, respectively.

In this case, as the light-sensitive composition, there have widely been used diazo resins such as condensates of p-diazodiphenylamine and formaldehyde.

On the other hand, as an aqueous alkaline developer composition used for developing an exposed presensitized plate for use in making a lithographic printing plate (hereinafter referred to as "PS plate") in which the foregoing diazo resin is employed, there have been proposed a variety of compositions such as those disclosed in Japanese Patent Unexamined Publication (hereinafter referred to as "J.P. KOKAI") No. Sho 51-77401 which comprises benzyl alcohol, an anionic surfactant, an alkaline agent and water; those disclosed in J.P. KOKAI No. Sho 53-44202 (= U.S. Pat. 4,186,006) which consists of an aqueous solution containing benzyl alcohol, an anionic surfactant and a water-soluble sulfite; and those disclosed in J. P. KOKAI No. Sho 55-155355 which comprises an organic solvent whose solubility in water is not more than 10% by weight at ordinary temperature, an alkaline agent and water.

All these developer compositions comprise organic substances such as organic solvents and surfactants. However, organic solvents in general suffer from various drawbacks. For instance, they have toxicity and give out bad smell, are liable to easily catch a fire and the exhaust liquid must be treated prior to the disposal so that it certainly fulfills the BOD requirements. Thus, the processing cost becomes high.

There have also been proposed developer compositions substantially free of these organic substances (for instance, organic solvents) such as those disclosed in J.P. KOKAI No. Sho 59-84241 (= U.S. Pat. 4,500,625). However, these developer compositions are exclusively used in the development of positive-working PS plates whose light-sensitive layer comprises an o-naphthoquinonediazide compound as a light-sensitive compound. On the other hand, diazo resins are not soluble in an alkaline solution. Therefore, there are observed various drawbacks when these developer compositions substantially free of organic substances are employed for the development of the PS plates in which the foregoing diazo resin is used for forming the light-sensitive layer thereof. More specifically, such a PS plate cannot be developed without causing any residue in non-image parts and the unexposed portions causes yellowing. Thus, these developer compositions do not show proper developability for these negative-working PS plates.

In this respect, the term "substantially free of organic solvents herein means that the developer composition does not contain any organic solvents in an amount at which any inconvenience in respect of environmental hygiene, safety or workability is caused. More specifically, in the present invention, the amount of the organic solvents in the developer composition is not more than 2% by weight and preferably not more than 1% by weight on the basis of the total weight of the developer composition.

## SUMMARY OF THE INVENTION

Accordingly, a principal object of the present invention is to provide a method for forming images in which a light-sensitive composition containing, as a light-sensitive substance, a diazo resin whose solubility in an alkaline aqueous solution is highly improved is imagewise exposed to light and then the light-sensitive composition is developed with an aqueous alkaline developer substantially free of organic solvents to thus give images. The method makes it possible to solve the aforementioned problems associated with the conventional techniques, for instance, those concerning hygiene such as toxicity and giving out of bad smell during operations, those concerning safety such as catching a fire and a gas explosion and those concerning workability such as foaming and environmental pollution by the exhaust liquid.

Another object of the present invention is to provide a method for forming images which makes it possible to minimize the cost.

The inventors of this invention have conducted various studies to achieve the foregoing objects, have found that the objects can effectively be attained by the use of a novel light-sensitive composition and thus have completed the present invention.

According to the present invention, there is provided a method for forming images which comprises the steps of, in order, imagewise exposing to light a light-sensitive material comprising a support having thereon a light-sensitive layer containing a light-sensitive co-condensed diazo resin having a structural unit derived from an aromatic compound having at least one of carboxyl and hydroxyl groups and a structural unit derived from an aromatic diazonium compound to form light- exposed and light-unexposed areas in the light-sensitive layer, and developing the light-sensitive material with an aqueous alkaline developer substantially free from an organic solvent to remove the light-unexposed areas of the light-sensitive layer.

DESCRIPTION OF THE PREFERRED EMBODIMENTS OF THE INVENTION

The aromatic compounds having at least one of carboxyl and hydroxyl groups used in the present invention are those comprising an aromatic ring structure substituted with at least one carboxyl group and/or an aromatic ring structure substituted with at least one hydroxyl group in the molecule. In this case, the carboxyl group and the hydroxyl group may directly be attached to the corresponding aromatic ring structure, respectively.

Preferred examples of the aromatic ring structure are benzene and naphthalene.

The foregoing carboxyl and hydroxyl groups may directly be bonded to the corresponding aromatic ring structure or may be bonded thereto through a connecting group.

In the present invention, the number of the carboxyl groups bonded per aromatic ring is preferably 1 or 2, while that of the hydroxyl groups bonded per aromatic ring preferably ranges from 1 to 3. In addition, preferred connecting groups are, for instance, alkylene groups having 1 to 4 carbon atoms.

At least two un-substituted sites must be present on the aromatic ring structure of at least one aryl group substituted with at least one hydroxyl group in order for the foregoing aromatic compound to be condensed with an aldehyde or a ketone.

Specific examples of the aromatic compounds having carboxyl and hydroxyl groups in the molecule include salicylic acid , 4-methylsalicylic acid, 6-methylsalicylic acid, 4-ethylsalicylic acid, 6-propylsalicylic acid, 6-laurylsalicylic acid, 6-stearylsalicylic acid, 4,6-dimethylsalicylic acid, p-hydroxybenzoic acid, 2-methyl-4-hydroxybenzoic acid, 6-methyl-4-hydroxybenzoic acid, 2,6-dimethyl-4-hydroxybenzoic acid, 2,4-dihydroxybenzoic acid, 2,4-dihydroxy-6-methylbenzoic acid, 2,6-dihydroxybenzoic acid, 2,6-dihydroxy-4-benzoic acid, 4-chloro-2, 6-dihydroxybenzoic acid, 4-methoxy-2,6-dihydroxybenzoic acid, gallic acid, fluoroglucincarboxylic acid, 2,4,5-trihydroxybenzoic acid, m-galloylgallic acid, tannic acid, m-benzoylgallic acid, m-(p-toluyl)gallic acid, protocatechuoyl-gallic acid, 4,6-dihydroxyphthalic acid, (2,4-dihydroxyphenyl) acetic acid, (2,6-dihydroxyphenyl)acetic acid, (3,4,5-trihydroxyphenyl)acetic acid, p-hydroxymethylbenzoic acid, p-hydroxyethylbenzoic acid, 4-(p-hydroxyphenyl)methylbenzoic acid, 4-(o-hydroxybenzoyl)benzoic acid, 4-(2,4-dihydroxybenzoyl) benzoic acid, 4-(p-hydroxyphenoxy)benzoic acid, 4-(p-hydroxyanilino)benzoic acid, bis(3-carboxy-4-hydroxyphenyl)amine, 4-(p-hydroxyphenylsulfonyl)benzoic acid and 4-(p-hydroxyphenylthio)benzoic acid. Among these, preferred are salicylic acid, p-hydroxybenzoic acid, 2,4-dihydroxybenzoic acid, gallic acid, fluoroglucincarboxylic acid and 4-(p- hydroxyanilino)benzoic acid.

In addition, specific examples of the aromatic compounds having a carboxyl group in the molecule are p-methoxybenzoic acid, 2,4-dimethoxybenzoic acid, 2,4-dimethylbenzoic acid, p-phenoxybenzoic acid, p-methoxyphenyl acetic acid, phenoxyacetic acid, 4-anilinobenzoic acid, 4-(m-methoxyanilino)benzoic acid, 4-(p-methoxybenzoyl)benzoic acid, 4-(p-methylanilino)benzoic acid and 4-phenylsulfonylbenzoic acid. Among these, preferred are 2,4-dimethoxybenzoic acid, p-phenoxybenzoic acid, phenoxyacetic acid, 4-anilinobenzoic acid, 4-(m-methoxyanilino) benzoic acid and 4-(p-methylanilino)benzoic acid.

In particular, aromatic compounds having a phenolic hydroxyl group are preferably used as the aromatic compounds having a hydroxyl group in the molecule and examples thereof are phenol, (o-, m-, p-)cresol, xylenol, resorcin, 2-methylresorcin, (o-, m-, p-)methoxyphenol, m-ethoyphenol, catechol, fluoroglucin, p-hydroxyethylphenol, naphthol, pyrogallol, hydroquinone, p-hydroxybenzyl alcohol, 4-chlororesorcin, biphenyl-4,4′-diol, 1,2,4-benzenetriol, bisphenol A, 2,4-dihydroxybenzophenone, 2,3,4-trihydroxybenzophenone, p-hydroxyacetophenone, 4,4′-dihydroxydiphenyl ether, 4, 4′-dihydroxydiphenylamine, 4,4′-dihydroxysulfone, 4,4′-dihydroxydiphenylsulfide and cumylphenol. Particularly preferred examples are p-cresol, resorcin, 2-methylresorcin, pyrogallol, p-methoxyphenol, 4,4′-dihydroxydiphenyl ether, 4,4′-dihydroxydiphenylamine and 2,3,4-trihydroxybenzophenone.

The aromatic diazonium compounds which can be used in this invention include those conventionally

known in the art. Specific examples of the aromatic diazonium compounds represented by the general formula (I) which may be used in the present invention are as follows:

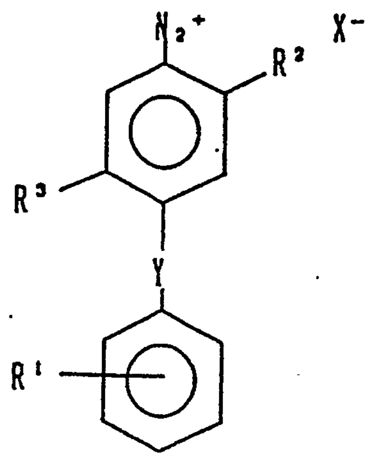

(I)

In the general formula (I), $R^1$ represents a hydrogen atom, a substituted or unsubstituted alkyl group, an alkoxy group, a hydroxyl group, a carboxy ester group or a carboxyl group, preferably a hydrogen atom, an alkyl group having 1 to 5 carbon atoms, an alkoxy group having 1 to 4 carbon atoms or a hydroxyl group; $R^2$ represents a hydrogen atom, an alkoxy group or an alkyl group, preferably a hydrogen atom or an alkoxy group having 1 to 4 carbon atoms; $R^3$ represents a hydrogen atom, an alkoxy group or an alkyl group, preferably a hydrogen atom.

$X^-$ represents an anion, preferably those derived from inorganic or organic acids having a pKa value of not more than 4 and specific examples thereof include those derived from hydrohalogenic acids such as hydrofluoric acid, hydrochloric acid, hydrochloric acid-zinc chloride complex, hydrobromic acid; sulfuric acid, nitric acid, phosphoric acid (pentavalent phosphorus atom-containing acid), in particular orthophosphoric acid; inorganic iso- and hetero polyacids such as phosphotungstic acid, phosphomolybdic acid; aliphatic or aromatic phosphonic acids or half esters thereof; arsonic acid, phosphinic acid, fluorocarboxylic acids such as trifluoroacetic acid, amidosulfonic acids, selenic acid, borofluoric acid, hexafluorophosphoric acid, perchloric acid and aliphatic and aromatic sulfonic acids.

Y represents -NH-, -O- or -S- and preferably -NH-.

Specific examples of the aromatic diazonium compounds represented by formula (I) include salts of compounds such as 4-diazodiphenylamine, 4′-hydroxy-4-diazodiphenylamine, 4′-methyl-4-diazodiphenylamine, 4′-ethyl-4-diazodiphenylamine, 4′-n-propyl-4-diazodiphenylamine, 4′-i-propyl-4-diazodiphenylamine, 4′-n-butyl-4-diazodiphenylamine, 4′-hydroxymethyl-4-diazodiphenylamine, 4′-β-hydroxyethyl-4-diazodiphenylamine, 4′-γ-hydroxypropyl-4-diazodiphenylamine, 4′-methoxymethyl-4-diazodiphenylamine, 4′-ethoxymethyl-4-diazodiphenylamine, 4′-β-methoxyethyl-4-diazodiphenylamine, 4′-β-ethoxyethyl-4-diazodiphenylamine, 4′-carboxy-4-diazodiphenylamine, 3-methyl-4-diazodiphenylamine, 3-ethyl-4-diazodiphenylamine, 3′-methyl-4-diazodiphenylamine, 3,3′-dimethyl-4-diazodiphenylamine, 2′-carboxy-4-diazodiphenylamine, 4-diazo-4′-methoxydiphenylamine, 4-diazo-4′-ethoxydiphenylamine, 4-diazo-4′-propoxydiphenylamine, 4-diazo-3-methoxydiphenylamine, 4-diazodiphenyl ether, 4′-methyl-4-diazodiphenyl ether, 3,4′-dimethyl-4-diazodiphenyl ether, 4′-carboxy-4-diazodiphenyl ether, 3,3′-dimethyl-4-diazodiphenyl ether, 4-diazodiphenyl sulfide and 4′-methyl-4-diazodiphenyl sulfide.

Moreover, the aromatic diazonium compounds used in this invention include salts of 3-methoxy-4-morpholinobenzene diazonium, 3-methoxy-4-N,N-dimethylaminobenzene diazonium and 8-methoxy-2-naphthalene diazonium.

Among these, particularly preferred aromatic diazonium compounds are 4-diazodiphenylamine salts, 4-diazo-4′-methoxydiphenylamine salts, 4-diazo-4′-ethoxydiphenylamine salts and 4-diazo-3-methoxydiphenylamine salts.

The condensed resin comprising structural repeating units derived from aromatic compounds carrying at least one of carboxyl and hydroxyl groups and aromatic diazonium compounds, which are condensed with aldehydes or ketones (hereinafter referred to as "diazo co-condensed resins") can be prepared according to any known methods as disclosed in Photo. Sci. Eng., 17 , p. 33 (1973); and U.S. Patent Nos. 2,063,631 and 2,679,498. More specifically, they can be prepared by polycondensing a diazonium salt, an aromatic compound carrying carboxyl and hydroxyl groups and an aldehyde such as para-formaldehyde,

acetaldehyde or benzaldehyde or a ketone such as acetone or acetophenone, in a sulfuric acid, phosphoric acid or hydrochloric acid solution.

Moreover, any arbitrary combinations of the aromatic compounds carrying carboxyl and/or hydroxyl groups in the molecule, the aromatic diazo compounds and the aldehydes or ketones may be used in the present invention and each component scan be used alone or in combination. The co-condensation can be performed in the presence of a co-condensable phenol compound free of a carboxyl group.

In this case, the ratio of the aromatic compound carrying at least one of carboxyl and hydroxyl groups to the aromatic diazo compound to be charged ranges from 1:0.1 to 0.1:1, preferably 1:0.2 to 0.2:1, more preferably 1:0.5 to 0.2:1. On the other hand, the molar ratio of the total amount of the the aromatic compound carrying at least one of carboxyl and hydroxyl groups and the aromatic diazo compound to that of the aldehyde or ketone usually ranges from 1:0.6 to 1.5, preferably 1:0.7 to 1.2. These components are reacted at a low temperature for a short period of time, for instance, in the order of 3 hours to thus give a desired diazo co-condensed resin.

The counter-anions for the diazo resins used in the present invention stably form salts with the diazo resins and the counter-anion makes the diazo resin soluble in an organic solvent. The counter-anions are, for instance, those derived from organic carboxylic acids such as decanoic acid and benzoic acid; organophosphoric acids such as phenyl phosphoric acid and organic sulfonic acids. Specific examples of the counter-anions are those derived from hydrohalogenic acids such as hydrofluoric acid, hydrochloric acid and hydrobromic acid; sulfuric acid, nitric acid, phosphoric acid (pentavalent phosphorus atom-containing acid), in particular orthophosphoric acid, inorganic iso- and hetero polyacids such as phosphotungstic acid, phosphomolybdic acid; aliphatic or aromatic phosphonic acids or half esters thereof; arsonic acid, phosphinic acid, fluorocarboxylic acids such as trifluoroacetic acid, amidosulfonic acids, selenic acid, tetrafluoroboric acid, halogen atom-containing Lewis acids such as hexafluorophosphoric acid, perhalogenic acids such as $HClO_4$ and $HIO_4$; aliphatic and aromatic sulfonic acids (for instance, alkanesulfonic acids such as methanesulfonic acid and dodecanesulfonic acid; fluoroalkanesulfonic acids such as trifluoromethanesulfonic acid and chloroethanesulfonic acid; laurylsulfonic acid, dioctylsulfosuccinic acid, dicyclohexylsulfosuccinic acid, camphorsulfonic acid, tolyloxy-3-propanesulfonic acid, nonylphenoxy-3-propanesulfonic acid, nonylphenoxy-4-butanesulfonic acid, dibutylphenoxy-3-propanesulfonic acid, diaminophenoxy-3-propanesulfonic acid, dinonylphenoxy-3-propanesulfonic acid, dibutylphenoxy-4-butanesulfonic acid, dinonylphenoxy-4-butanesulfonic acid, benzenesulfonic acid, toluenesulfonic acid, mesitylenesulfonic acid, p-chlorobenzenesulfonic acid, 2,5-dichlorobenzenesulfonic acid, sulfosalicylic acid, 2,5-dimethylbenzenesulfonic acid, p-acetylbenzenesulfonic acid, 5-nitro-o-toluenesulfonic acid, 2-nitrobenzenesulfonic acid, 3-chlorobenzenesulfonic acid, 3- bromobenzenesulfonic acid, 2-chloro-5-nitrobenzenesulfonic acid, butylbenzenesulfonic acid, octylbenzenesulfonic acid, decylbenzenesulfonic acid, butoxybenzenesulfonic acid, dodecyloxybenzenesulfonic acid, 2-methoxy-4-hydroxy-5-benzoylbenzenesulfonic acid, 2-hydroxy-4-methoxybenzophenone-5-sulfonic acid, hydroxysulfonic acid, 4-acetylbenzenesulfonic acid, dimethyl-5-sulfoisophthalate, anthraquinonesulfonic acid, isopropylnaphthalenesulfonic acid, butylnaphthalenesulfonic acid, hexylnaphthalenesulfonic acid, octylnaphthalenesulfonic acid, butoxynaphthalenesulfonic acid, dodecyloxynaphthalenesulfonic acid, dibutylnaphthalenesulfonic acid, dioctylnaphthalenesulfonic acid, triisopropylnaphthalenesulfonic acid, tributylnaphtha-lenesulfonic acid, 1-naphthol-5-sulfonic acid, naphthalene-1-sulfonic acid, naphthalene-2-sulfonic acid, 1,8-dinitro-naphthalene-3,6-disulfonic acid, 4,4′-diazido-stilbene-3, 3′-disulfonic acid, 1,2-naphthoquinone-2-diazido-4-sulfonic acid, 1,2-naphthoquinone-2-diazido-5-sulfonic acid and 1,2-naphthoquinone-1-diazido-4-sulfonic acid); and hydroxyl group-containing aromatic compounds such as 2,2′,4,4′-tetrahydroxybenzophenone, 1,2,3-trihydroxybenzophenone and 2,2′,4-trihydroxybenzophenone; as well as mixture thereof. Among these anions, particularly preferred are those derived from hexafluorophosphoric acid, methanesulfonic acid, dibutylnaphthalenesulfonic acid, 2-methoxy-4-hydroxy-5-benzoylbenzenesulfonic acid and 2-hydroxy-4-methoxybenzophenone -5-sulfonic acid.

Specific examples of the co-condensed diazo resins used in the present invention are salicylic acid-4-diazo-4′-methoxydiphenylamine • hexafluorophosphate-formaldehyde resin, 4-methylsalicylic acid-4-diazo-4′-methoxydiphenylamine i& hexafluorophosphate-formaldehyde resin, p-hydroxybenzoic acid-4-diazo-4′-methoxydiphenylamine • hexafluorophosphate-formaldehyde resin, p-hydroxybenzoic acid-4-diazo-3-methoxydiphenylamine • hexafluorophosphate-formaldehyde resin, gallic acid-4-diazo-4′-ethoxydiphenylamine•2-hydroxy-4-methoxybenzophenone-5-sulfonate-formaldehyde resin, 2,4-dihydroxybenzoic acid-4-diazo-4′-methoxydiphenylamine • hexafluorophosphate-formaldehyde resin, 4-(p-hydroxyanilino) benzoic acid-4-diazo-4′-methoxydiphenylamine • hexafluorophosphate-formaldehyde resin, p-cresol-4-diazo-3-methoxydiphenyl-amine • hexafluorophosphate-benzaldehyde resin, resorcin-4-diazo-4′-methoxydiphenylamine • hexafluorophosphate-formaldehyde resin, 2-methylresorcin-4-diazo-4′-methoxydiphenylamine • hexafluorophos-phate-formaldehyde resin, pyrogallol-4-diazo-3-methoxydiphenyl-amine •

2-hydroxy-4-methoxybenzophenone-5-sulfonate-formaldehyde resin, pyrogallol-4-diazo-4′-methoxydiphenylamine • hexafluorophosphate-formaldehyde resin, 2,4-dihydroxy-benzophenone-4-diazo-4′-methoxydiphenylamine • hexafluorophosphate-formaldehyde resin, 4,4′-dihydroxydiphenyl-amine-4-diazo-4′-ethoxydiphenylamine • hexafluorophosphate-formaldehyde resin, 2,4-dimethoxybenzoic acid-4-diazo4′-methoxydiphenylamine • hexafluorophosphate- phenoxyacetic acid-4-diazodiphenylamine • hexafluorophosphate-formaldehyde resin, formaldehyde resin, 4-anilinobenzoic acid-4-diazo-4′-methoxydiphenylamine • hexafluorophosphate-formaldehyde resin, p-phenoxybenzoic acid-4-diazo-4′-methoxydiphenylamine • hexafluorophosphate-formaldehyde resin, salicylic acid-4-diazodiphenylamine • hexafluorophosphate-formaldehyde resin, 4-methylsalicylic acid-4-diazo-4′-methyldiphenylamine • hexafluorophosphate-formaldehyde resin, p-hydroxybenzoic acid-4-diazodiphenylamine • hexafluorophosphate-formaldehyde resin, p-hydroxybenzoic acid-4-diazo-3-methyldiphenylamine • hexafluorophosphate-formaldehyde resin, gallic acid-4-diazo-4′-ethyldiphenylamine • 2-hydroxy-4-methoxybenzophenone-5-sulfonate-formaldehyde resin, 2,4-dihydroxybenzoic acid-4-diazodiphenylamine • hexafluorophosphate-formaldehyde resin, 4-(p-hydroxyanilino)benzoic acid-4-diazodiphenylamine • hexafluorophosphate-formaldehyde resin, p-cresol-4-diazo-3-methyldiphenylamine • hexafluorophosphate-benzaldehyde resin, resorcin-4-diaziodiphenylamine • hexafluorophosphate-formaldehyde resin, 2-methylresorcin-4-diazodiphenylamine • hexafluorophosphate-formaldehyde resin, pyrogallol-4-diazodiphenylamine • 2-hydroxy-4-methoxybenzophenone-5-sulfonate-formaldehyde resin, pyrogallol-4-diazodiphenylamine • hexafluorophosphate-formaldehyde resin, 2,4-dihydroxybenzophenone-4-diazodiphenylamine • hexafluorophosphate-formaldehyde resin, 4,4′-dihydroxydiphenylamine-4-diazo-4′-ethyldiphenylamine • hexafluorophosphate-formaldehyde resin, 2,4-dimethoxybenzoic acid-4-diazodiphenylamine • hexafluorophosphate-formaldehyde resin, phenoxyacetic acid-4-diazo-diphenylamine • hexafluorophosphate-formaldehyde resin, 4-anilinobenzoic acid-4-diazo-4′-methyldiphenylamine • hexafluorophosphate-formaldehyde resin and p-phenoxybenzoic acid-4-diazodiphenylamin e • hexafluorophosphate-formaldehyde resin. Among these compounds, particularly preferred compounds are salicylic acid-4-diazo-4′-methoxydiphenylamine • hexafluorophosphate-formaldehyde resin, p-hydroxybenzoic acid-4-diazo-4′-methoxydiphenylamine • hexafluorophosphate-formaldehyde resin, 2,4-dihydroxybenzoic acid-4-diazo-4′-methoxydiphenylamine • hexafluorophosphate-formaldehyde resin, resorcin-4-diazo-4′-methoxydiphenylamine • hexafluorophosphate-formaldehyde resin, pyrogallol-4-diazo-4′-methoxydiphenylamine • hexafluorophosphat e-formaldehyde resin, 2,4-dihydroxybenzophenone-4-diazo-4′-methoxydiphenylamine • hexafluorophosphate-formaldehyde resin, salicylic acid-4-diazodiphenylamine • 2-hydroxy-4-methoxyben zophenone-5-sulfonate-formaldehyde resin, p-hydroxybenzoic acid-4-diazodiphenylamine • hexafluorophosphate-formaldehyde resin, phenoxyacetic acid-4-diazodiphenylamine • hexafluorophosphate-formaldehyde resin, phenoxyacetic acid-4-diazodiphenylamine-dodecylbenzenesulfonate-formaldehyde resin, 2, 4-dihydroxybenzoic acid-4-diazodiphenylamine • 2-hydroxy-4-methoxybenzophenone-5-sulfonate-formaldehyde resin, resorcin-diazodiphenylamine • methanesulfonate-formaldehyde resin, pyrogallol-4-diazo-4′-methyldiphenylamine • hexafluorophosphate- formaldehyde resin and 2,4-dihydroxybenzophenone-4-diazodiphenylamine • dibutylnaphthalenesulfonate-formaldehyde resin.

The molecular weight of the co-condensed diazo resins used in the invention may be arbitrarily controlled by adjusting the molar ratio of the monomers to be condensed and the conditions for the co-condensation, but it in general ranges from anout 400 to 100,000, preferably about 800 to 5,000 in order that the co-condensed resins can effectively be used to achieve the intended object of the present invention.

Typical Examples for preparing the co-condensed diazo resins of the present invention will now be described below.

(Preparation Example 1)

3.5 g (0.025 mole) of p-hydroxybenzoic acid and 22.0 g (0.075 mole) of 4-diazo= 4′-methoxydiphenylamine sulfate were dissolved in 90 g of conc. sulfuric acid while cooling the reaction system with water. Then, 2.7 g (0.09 mole) of paraformaldehyde was gradually added to the reaction system. In this respect, the addition of paraformaldehyde must be performed so that the reaction temperature does not exceeds 10 °C. Thereafter, the reaction system was stirred for additional 2 hours under ice cooling. The reaction mixture was poured into 1 ℓ of ethanol while it was ice-cooled and the resulting precipitates were filtered off. The precipitates were washed with ethanol, dissoved in 200 mℓ of pure water and a cold concentrated solution of 10.5 g of zinc chloride in water was added to the resulting solution. The precipitates formed were removed by filtration, washed with ethanol and then dissolved in 300 mℓ of pure

water. To the resulting solution, there was added a cold concentrated solution of 13.7 g of ammonium hexafluorophosphate in water. The resulting precipitates were removed by filtration, washed with water and dried at 30° C day and night to thus give a diazo co-condensed resin-1.

The weight average molecular weight of the diazo co-condensed resin-1 was determined by the gel permeation chromatography (GPC) technique and was found to be about 2,300.

(Preparation Example 2)

5.6 g (0.040 mole) of p-hydroxybenzoic acid and 17 g (0.060 mole) of 4-diazodiphenylamine sulfate were dissolved in 90 g of concentrated sulfuric acid while cooling the reaction system with water. Then, 3.0 g (0.10 mole) of paraformaldehyde was slowly added to the reaction system. In this respect, the addition of paraformaldehyde must be performed so that the reaction temperature does not exceeds 10° C. Thereafter, the same procedures used in Preparation Example 1 were repeated to obtain a diazo co-condensed resin-2.

The weight average molecular weight of the co-condensed diazo resin-2 was determined by the GPC technique and was found to be about 2,100.

(Preparation Example 3)

7.61 g (0.0500 mole) of phenoxyacetic acid and 14.7 g (0.0500 mole) of 4-diazodiphenylamine were dissolved in 70 ml of conc. sulfuric acid while cooling the reaction system with ice. Then, 3.14 g (0.100 mole) of paraformaldehyde was added to the reaction system. In this respect, the addition of paraformaldehyde was performed so that the reaction temperature did not exceed 10 ° C. Thereafter the reaction system was stirred for additional 2 hours under ice cooling. The resulted reaction mixture was poured into 1 ℓ of isopropanol while it was ice cooling to separate the yellow precipitates. The yellow precipitates thus formed were collected by filtration and washed with isopropanol to obtain bisulfate salt of co-condensate of phenoxyacetic acid and 4-diazodiphenylamine with formaldehyde.

The co-condensate was dissolved in 400 ml of water. To the resulting solution, there was added a solution of 27.7 g (0.0600 mole) of sodium dodecylbenzenesulfonate in 600 ml of water under vigorous stirring. The resulting yellow precipitates formed were collected by filtration and dried to obtain 21 g of dodecylbenzenesulfonate of co-condensate of phenoxyacetic acid and 4-diazodiphenylamine with formaldehyde (diazo co-condensed resin-3).

The weight average molecular weight of the coupling product between the diazo co-condensed resin-3 and 1-phenyl-3-methyl-5-pyrazolone was determined by the GPC technique and was found to be 2,670.

Other co-condensed diazo resins listed above can likewise be prepared in the same manner used in Preparation Examples 1.

The foregoing light-sensitive co-condensed diazo resins are desirably used in combination with a lypophilic polymeric compound soluble in or swellable with an alkaline solution as a binder.

Examples of such lypophilic polymeric compounds are copolymers having a molecular weight ranging from 10,000 to 200,000 and structural units derived from monomers (1) to (13) listed below:

(1) (meth)acrylamides, (meth)acrylates and hydroxystyrenes having an aromatic hydroxyl group such as N-(4-hydroxyphenyl) (meth)acrylamides, o-, m- and p-hydroxyphenyl-(meth)acrylates and o-, m- and p-hydroxystyrene;

(2) (meth)acrylates having an aliphatic hydroxyl group such as 2-hydroxyethyl (meth)acrylates;

(3) unsaturated carboxylic acids such as acrylic acid, methacrylic acid, maleic anhydride and itaconic acid;

(4) (substituted) alkyl acrylates such as methyl acrylate, ethyl acrylate, propyl acrylate, butyl acrylate, amyl acrylate, hexyl acrylate, octyl acrylate, 2-chloroethyl acrylate, glycidyl acrylate and N-dimethylaminoethyl acrylate;

(5) (substituted)alkyl methacrylates such as methyl methacrylate, ethyl methacrylate, propyl methacrylate, butyl methacrylate, amyl methacrylate, cyclohexyl methacrylate, 4-hydroxybutyl methacrylate, glycidyl methacrylate and N-dimethylaminoethyl methacrylate;

(6) (meth)acrylamides such as (meth)acrylamides, N- methylol(meth)acrylamides, N-ethylacrylamide, N-hexylmethacrylamide, N-cyclohexylacrylamide, N-hydroxyethylacrylamide, N-phenylacrylamide, N-nitrophenylacrylamide and N-ethyl-N-phenylacrylamide;

(7) vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether;

(8) vinyl esters such as vinyl acetate, vinyl chloroacetate, vinyl butyrate and vinyl benzoate;

(9) styrenes such as styrene, α -methylstyrene, methylstyrene and chloromethylstyrene;

(10) vinyl ketones such as methyl vinyl ketone, ethyl vinyl ketone, propyl vinyl ketone and phenyl vinyl ketone;

(11) olefins such as ethylene, propylene, isobutylene, butadiene and isoprene;

(12) N-vinylpyrrolidone, N-vinylcarbazole, 4-vinylpyridine, acrylonitrile, methacrylonitrile or the like; and

(13) unsaturated imides such as maleimide, N-acryloylacrylamide, N-acetylmethacrylamide, N-propionylmethacrylamide and N-(p-chlorobenzoyl)methacrylamide.

The foregoing monomers may be copolymerized in the presence of another monomer copolymerizable with the former to obtain the copolymers used as the binder in the present invention. The copolymers used as the binder also include those obtained by modifying the copolymers obtained from the foregoing monomers with, for instance, glycidyl (meth)acrylate. However, the present invention is not restricted to these specific ones.

More specifically, copolymers derived from the monomers (1) and (2) listed above and having hydroxyl groups in the copolymer are preferably employed in the invention, more preferably the copolymers have aromatic hydroxyl groups.

The copolymer preferably comprises the structural units derived from the unsaturated carboxylic acid (3) listed above and the carboxyl value of the copolymer preferably ranges from 0 to 3 meq/g, more preferably 0.5 to 1.5 meq/g.

The foregoing copolymer preferably has a molecular weight ranging from 10,000 to 150,000.

There may optionally be used other resins such as polyvinyl butyral resins, polyurethane resins, polyamide resins, epoxy resins, novolak resins and/or natural resins in combination with the foregoing copolymers as the binder.

The lypophilic polymeric compounds used in the present invention are added to the light-sensitive composition in an amount usually ranging from 40 to 99% by weight, preferably 50 to 95% by weight on the basis of the total weight of the solid contents of the composition. On the other hand, the amount of the light-sensitive diazo resins used in the present invention usually ranges from 1 to 60% by weight, preferably 3 to 30% by weight.

Preparation Examples of the foregoing lypophilic polymers used as a binder in the light-sensitive composition of the present invention will be given below.

(preparation of Lypophilic Polymeric Compound 1)

A mixture of 18 g of N-(4-hydroxyphenyl)methacrylamide, 13 g of acrylonitrile, 66 g of ethyl acrylate, 8.6 g of methacrylic acid and 1.642 g of azobisisobutylonitrile was sdissolved in 112 m ℓ of a 1:1 mixture of acetone-methanol, the air in the reactor was replaced with nitrogen gas and the solution was heated at 60° C for 8 hours.

After the reaction was finished, the reaction solution was poured into 5ℓ of water with stirring and the resulting white precipitates were removed by filtration to thus obtain 88 g of the intended lypophilic polymeric compound 1.

The weight average molecular weight of the lypophilic polymeric compound 1 was determined by gel permeation chromatography (hereinafter referred to as "GPC") and found to be 75,000.

(Preparation of Lypophilic Polymeric Compound 2)

A solution of a mixture comprising 5.0 g of 2-hydroxyethyl methacrylate, 20 g of N-(4-hydroxyphenyl)-acrylamide, 60 g of methyl methacrylate, 8.0 g of methacrylic acid and 1.2 g of benzoyl peroxide was dropwise added to 300 g of ethylene glycol monomethyl ether heated to 100° C over 2 hours. After the dropwise addition, 300 g of ethylene glycol monomethyl ether and 0.3 g of benzoyl peroxide were added to the reaction system and the mixture as such was reacted for 4 hours. After the completion of the reaction, the reaction system was diluted with methanol, poured into 5ℓ of water with stirring, the resulting white precipitates were removed by filtration and dried to give 86 g of the intended lypophilic polymeric compound 2.

The weight average molecular weight of the lypophilic polymeric compound 2 was determined by GPC and found to be 82,000.

(Preparation of Lypophilic Polymeric Compound 3)

As in the Preparation Example 2, a solution of a mixture comprising 20 g of N-(4-hydroxyphenyl) methacrylate, 20 g of 2-cyanoethyl methacrylate, 50 g of ethyl methacrylate, 10 g of methacrylic acid and 1.2 g of benzoyl peroxide was dropwise added to ethylene glycol monomethyl ether to obtain 85 g of the intended lypophilic polymeric compound 3.

The weight average molecular weight of the lypophilic polymeric compound 3 was determined by GPC and found to be 69,000.

The light-sensitive layer used in the present invention may further comprises a dye. Such a dye is used for the purposes of obtaining visible images after exposure to light (visualization of images by exposure to light) and of obtaining visible images after development.

As such dyes, there are preferably used those whose color tone is changed through the reaction with a free radical or an acid. The term "change in color tone" herein means color development, decolorization or change from a color to a different one. Preferred dyes are those forming salts through a reaction with acids to thus change the color tone of the light- sensitive layer.

Examples of decolorizers which cause decolorization or color change from a color to another one are triphenylmethane type, diphenylmethane type, oxazine type, xanthene type, iminonaphtho-quinone type, azomethine type or anthraquinone type dyes such as Victoria Pure Blue BOH (available from HODOGAYA CHEMICAL CO., LTD.), Oil Blue #603 (ORIENT CHEMICAL INDUSTRIES LTD.), Patent Pure Blue (available from Sumitomo Mikuni Chemical Co., Ltd.), Crystal Violet, Brilliant Green, Ethyl Violet, Methyl Violet, Methyl Green, Erythrosine B, Basic Fuchsine, Malachite Green, Oil Red, m-Cresol Purple, Rhodamine B, Auramine, 4-p-diethylaminophenyl iminaphthoquinone and cyano-p-diethylaminophenyl acetoanilide.

On the other hand, examples of the decolorizers which cause color development are leuco dyes and primary or secondary arylamine type dyes such as triphenylamine, diphenylamine, o-chloroaniline, 1,2,3-triphenylguanidine, naphthylamine, diaminodiphenylmethane, p,p′-bis-dimethylaminodiphenylamine, 1,2-dianilinoethylene, p,p′,p″-tris-dimethylaminotriphenylmethane, p,p′-bis-dimethylaminodiphenylmethyl-imine, p,p′,p″-triamino-o-methyltriphenylmethane, p,p′-bis-dimethylaminodiphenyl-4-anilinonaphthylmethane and p,p′,p″-triaminotriphenyl-methane.

Particularly preferred dyes are triphenylmethane type and diphenylmethane type dyes, more preferably triphenylmethane type dyes, in particular Victoria Pure Blue BOH.

The amount of the foregoing dyes to be incorporated into the light-sensitive layer in general ranges from about 0.5 to about 10% by weight and preferably about 1 to 5% by weight on the basis of the total weight of the layer.

The light-sensitive layer used in the present invention may further comprise other various additives.

Examples of these additives are agents for improving the coating properties of the composition such as alkyl ethers (e.g. , ethyl cellulose or methyl cellulose), fluorine atom-containing surfactants or nonionic surfactants (for instance, PLURONIC L-64 (available from ASAHI DENKA KOGYO K.K.); plasticizers for imparting flexibility and wear resistance to the resulting coated film (for instance, butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate or oligomers or polymers of (meth) acrylic acid); agents for improving ink receptivity of images (for instance, styrene-maleic anhydride copolymers half-esterified with an alcohol as disclosed in J.P. KOKAI No. Sho 55-527); and stabilizers (for instance, phosphoric acid, phosphorous acid, organic acids such as citric acid, oxalic acid, benzenesulfonic acid, naphthalenesulfonic acid, 4-methoxy-2-hydroxybenzophenone-5-sulfonic acid or tartaric acid). The amount of these additives to be incorporated into the light-sensitive composition varies depending on the kinds of the composition and the purposes of the addition, but in general they are used in an amount ranging from 0.01 to 30% by weight on the basis of the total weight of the composition.

Upon practically using the light-sensitive composition, it is applied onto a substrate to thus obtain a light-sensitive layer thereon. Examples of substrates usable in the present invention are metal plates such as an aluminum plate, an aluminum alloy plate, a zinc plate, a steel plate or plastic sheets such as polyethylene terephthalate or polypropylene sheets.

When the light-sensitive composition is used for forming the light-sensitive layer of PS plates, the composition is desirably applied onto a substrate of aluminum or an alloy thereof.

Examples of the substrates used in making PS plates are paper, plastic sheets such as polyethylene, polypropylene or polystyrene sheets; a laminate paper, metal plates such as aluminum (inclusive of alloys thereof), zinc or copper plates; plastic films such as cellulose diacetate, cellulose triacetate, cellulose propionate, polyethylene terephthalate, polyethylene, polypropylene, polycarbonate or polyvinyl acetal films; paper or plastic films which are laminated with a foil of the foregoing metal or to which a layer of the

foregoing metal is deposited; or a steel plate which is subjected to aluminum- or chromium-plating. Among these, preferred are aluminum substrates and composite substrates coated with aluminum layer.

The surface of these aluminum materials is desirably subjected to a surface-roughening treatment for enhancing the water retention thereof and the adhesion of the surface to the light-sensitive layer applied thereto.

As the surface-roughening methods, there may be mentioned, for instance, generally known brush graining, ball graining, electrolytic etching, chemical etching, liquid honing and sandblasting methods as well as combination thereof, preferably brush graining, electrolytic etching, chemical etching and liquid honing methods. Among these, preferred are those including an electrolytic etching method. Examples of the electrolytic bath used in the electrolytic etching treatment are aqueous solutions containing acids or alkalis or salts thereof, or these aqueous solutions containing organic solvents, in particular electrolytes which comprise hydrochloric acid, nitric acid or a salt thereof. The aluminum plates thus surface-roughened are optionally desmutted with an aqueous solution of an acid or an alkali. The aluminum plate thus obtained is desirably anodized, in particular in a bath containing sulfuric acid or phosphoric acid. Moreover, the aluminum plate may optionally be subjected to sealing treatment with an alkali silicate or hot water and other surface treatments such as those comprising dipping the plate in an aqueous solution of a water-soluble polymeric compound or potassium fluorozirconate.

In order to apply the foregoing light-sensitive composition onto a substrate, first the ingredients such as a light-sensitive diazo co-condensed resin, a lypophilic polymeric compound and other optional additives are dissolved in a proper solvent in the desired amounts thereof to thus obtain a coating solution of the light-sensitive composition, then the solution is applied onto the substrate and dried. Examples of such solvents usable in this operation are methyl cellosolve, ethyl cellosolve, dimethoxyethane, diethylene glycol monomethyl ether, diethylene glycol dimethyl ether, 1-methoxy-2-propanol, methyl cellosolve acetate, acetone, methyl ethyl ketone, methanol, dimethylformamide, dimethylacetamide, cyclohexanone, dioxane, tetrahydrofuran, methyl lactate, ethyl lactate, ethylene dichloride, dimethylsulfoxide, water or mixture thereof. The concentration of the solid contents of the light-sensitive composition in the coating solution desirably ranges from 1 to 50% by weight. In this case, the coated amount of the light-sensitive composition is in the order of about 0.2 to 10 $g/m^2$ (weighed after drying).

The light-sensitive composition thus applied onto the substrate is exposed to light through an original transparency carrying images and/or half tone dot images and then developed with an aqueous alkaline developer substantially free of organic solvents to thus give relief images negative to the original.

Examples of the alkaline agents for preparing the aqueous alkali developer substantially free of organic solvents according to the present invention are inorganic alkaline agents such as sodium silicate, potassium silicate, potassium hydroxide, sodium hydroxide, lithium hydroxide, sodium tertiary phosphate, sodium secondary phosphate, ammonium tertiary phosphate, ammonium secondary phosphate, sodium metasilicate, sodium bicarbonate, sodium borate, ammonium borate and ammonia; and organic amine compounds such as monomethylamine, dimethylamine, trimethylamine, monoethylamine, diethylamine, triethylamine, monoisopropylamine, diisopropylamine, n-butylamine, monoethanolamine, diethanolamine, triethanolamine, monoisopropanolamine, diisopropanolamine, ethyleneimine, ethylenediamine and pyridine. These alkaline agents may be used alone or in combination.

Among these alkaline agents, preferred are sodium silicate, potassium silicate, potassium hydroxide, sodium hydroxide, monoethanolamine, diethanolamine and triethanolamine and more preferably sodium silicate, potassium silicate, potassium hydroxide and sodium hydroxide. These preferred alkaline agents may be used singly or in combination with other alkaline agents.

The amount of these alkaline agents to be added to the developer composition ranges from 0.05 to 10% by weight, preferably 0.1 to 7% by weight on the basis of the total weight of the composition.

The developer composition may optionally comprise an anionic surfactant and/or an organic solvent. Examples of such anionic surfactants are salts of higher alcohol sulfate esters having 8 to 22 carbon atoms such as sodium salt of lauryl alcohol sulfate, sodium salt of octyl alcohol sulfate, ammonium salt of lauryl alcohol sulfate and secondary sodium alkyl sulfates; salts of aliphatic alcohol phosphate esters such as sodium salt of cetyl alcohol phosphate ester; salts of alkyl aryl sulfonic acids such as sodium salt of dodecylbenzenesulfonic acid, sodium salt of isopropylnaphthalenesulfonic acid and sodium salt of m-nitrobenzenesulfonic acid; sulfonic acid salts of alkylamides such as $C_{17}H_{33}CON(CH_3)CH_2CH_2SO_3Na$; and sulfonic acid salts of dibasic aliphatic acid esters such as sodium dioctyl sulfosuccinate and sodium dihexyl sulfosuccinate.

The amount of the anionic surfactant desirably ranges from 0.1 to 5% by weight on the basis of the total weight of the developer practically used. This is because, if it is less than 0.1% by weight, the desired effect thereof is not attained, while if it exceeds 5% by weight, various drawbacks are observed, for

instance, the dye which has been incorporated into the photohardenable light-sensitive composition is excessively dissolved out from the photohardened portions (so-called color blinging) and mechanical and chemical strength such as wear resistance of the photohardened images are impaired.

The aqueous alkaline developer used in the invention may optionally comprise a small amount of an organic solvent.

The organic solvents suitably used in the invention are those having a solubility in water of not more than about 10% by weight, preferably not more than 5% by weight. Specific examples thereof include 1-phenylethanol, 2-phenylethanol, 3-phenylpropanol-1, 4-phenylbutanol-1, 4-phenylbutanol-2, 2-phenylbutanol-1, 2-phenoxyethanol, 2-benzyloxyethanol, o-methoxybenzyl alcohol, m-methoxybenzyl alcohol, p-methoxybenzyl salcohol, benzyl alcohol, cyclohexanol, 2-methylcyclohexanol, 4-methylcyclohexanol and 3-methylcyclohexanol.

The amount of the organic solvent is not more than 2% by weight, preferably not more than 1% by weight on the basis of the total weight of the developer practically used.

The developer composition may optionally comprise other additives such as anti-foaming agents and softeners for hard water. Examples of the softeners for hard water include polyphospates such as $Na_2P_2O_7$, $Na_5P_3O_3$, $Na_3P_3O_9$, $Na_2O_4P(NaO_3P)$ $PO_3Na_2$ and Calgon (sodium polymetaphosphate); and aminopolycarboxylic acid and salts thereof such as ethylenediaminetetraacetic acid and sodium and potassium salts thereof, diethylenetriaminepentaacetic acid and sodium and potassium salts thereof, triethylenetetraminehexaaceticacid and sodium and potassium salts thereof, hydroxyethylethylenediamine triacetic acid and sodium and potassium salts thereof, nitrilotriacetic acid and sodium and potassium salts thereof, 1, 2-diaminocyclohexanetetraacetic acid and sodium and potassium salts thereof and 1,3-diamino-2-propanoltetraacetic acid and sodium and potassium salts thereof. The amount of these softeners for hard water varies depending on the hardness of hard water used and the amount thereof, but in general ranges from 0.01 to 5% by weight and preferably 0.01 to 0.5% by weight on the basis of the total weight of the developer practically used.

The aqueous alkaline developer used in the present invention may optionally comprises reducing inorganic salts. The reducing inorganic salts are preferably those having reducing action and being soluble in water and particularly preferred are salts of lower oxyacids. Specific examples thereof are sulfites such as sodium sulfite, potassium sulfite, ammonium sulfite, lithium sulfite, magnesium sulfite, sodium bisulfite and potassium bisulfite; and phosphites such as sodium phosphite, potassium phosphite, sodium hydrogen phosphite, potassium hydrogen phosphite, sodium dihydrogen phosphite and potassium dihydrogen phosphite. These salts may be used alone or in combination. Among these, preferred are alkali metal salts of sulfite. The amount of these reducing inorganic salts ranges from 0.001 to 30% by weight, preferably 0.01 to 10% by weight on the basis of the total weight of the developer composition.

The aqueous alkaline developer of the present invention may optionally comprise water-soluble pyrazolone compounds, alkali-soluble mercapto compounds or 1,3-dihydroxy aromatic compounds or salts thereof. These compounds may be used alone or in combination. The amount of these compounds in the developer composition is preferably not more than 10% by weight. The greater the amount of the compounds, the higher the ability thereof to prevent the occurrence of background contamination of non-image portions. However, if the amount thereof exceeds 10% by weight, the mechanical strength of the photohardened portions of a light-sensitive layer is impaired and when the developer containing the compound is used for making a lithographic printing plate, the printing durability of the resulting printing plate is possibly impaired.

As the foregoing alkali-soluble mercapto compounds, there may be mentioned, for instance, mercaptoacetic acid, 2-mercaptopropionic acid, 3-mercaptopropionic acid, 4-mercaptobutanoic acid, 2,4-dimercaptobutanoic acid, 2-mercaptotetradecanoic acid, 2-mercaptomyristic acid, mercaptosuccinic acid, 2,3-dimercaptosuccinic acid, cysteine, N-acetylcysteine, N-(2-mercaptopropionyl)glycine, N-(2-mercapto-2-methylpropionyl)glycine, N-3-mercaptopropionyl)glycine, N-(2-mercapto-2-methylpropionyl)cysteine, penicillamine, N-acetylpenicillamine, glycine• cysteine• glutamine condensate, N-(2,3-dimercaptopropionyl)glycine, 2-mercaptonicotinic acid, thiosalicylic acid, 3-mercaptobenzoic acid, 4-mercaptobenzoic acid, 3-carboxy-2-mercaptopyridine, 2-mercaptobenzothiazole-5-carboxylic acid, 2-mercapto-3-phenylpropenic acid, 2-mercapto-5-carboxyethylimidazole, 5-mercapto-1-(4-carboxyphenyl)tetrazole, N-(3,5-dicarboxyphenyl)-2-mercaptotetrazole, 2-(1,2-dicarboxyethylthio)-5-mercapto-1,3,4-thiadiazole, 2-(5-mercapto-1,3,4-thiadiazolylthio)hexanoic acid, 2-mercaptoethanesulfonic acid, 2,3-dimercapto-1-propanesulfonic acid, 2-mercaptobenzenesulfonic acid, 4-mercaptobenzenesulfonic acid, 3-mercapto-4-(2-sulfophenyl)-1,2,4-triazole, 2-mercaptobenzothiazole-5-sulfonic acid, 2-mercaptobenzimidazole-6-sulfonic acid, mercaptosuccinimide, 4-mercaptobenzenesulfonamide, 2-mercaptobenzimidazole-5-sulfonamide, 3-mercapto-4-(2-(methylamino-sulfonyl)ethoxy)toluene, 3-mercapto-4-(2-(methylsulfonylamino) ethoxy)toluene, 4-mercapto-N-(p-methylphenylsulfonyl)benzamide, 4-mercaptophenol, 3-mercaptophenol, 2-mercaptophenol, 3,4-dimercaptotoluene, 2-mercaptohydroquinone, 2-thiouracil, 3-hydroxy-2-mercaptopyrimidine, 4-hydroxythiophenol, 4-hydroxy-2-mercaptopyridine, 4,6-dihydroxy-2-mercaptopyrimidine, 2,3-dihydroxypropylmercaptan, 2-mercapto-4-octylphenol methanesulfonylaminoethyl ether, 2-mercapto-4-octylphenol or alkali metal, alkaline earth metal or organic amine salts thereof. Particularly preferred are thiosalicylic acid, N-(2,3-dimercaptopropionyl)glycine, 2-(1,2-dicarboxyethylthio)-5-mercapto-1,3,4-thiadiazole, N-(2-mercapto-2-methylpropionyl) cysteine and cysteine.

On the other hand, examples of the foregoing 1,3-dihydroxy aromatic compounds are resorcin, 1,3-dihydroxynaphthalene, 2-methylresorcin, 1,3-dihydroxy-2-methylnaphthalene, 2-propylresorcin, 2-ethylresorcin, 1,3-dihydroxy-2,7-dimethylnaphthalene or alkali metal, alkaline earth metal or organic amine salts thereof.

The pH value of the aqueous alkaline developer used in the invention is in general not less than 11, preferably not less than 12.

As such aqueous alkali developers substantially free of organic solvents, there may be used, for instance, developer compositions which are used for developing a positive-working PS plate after imagewise exposure to light to thus obtain a lithographic printing plate such as those disclosed in J.P. KOKAI Nos. Sho 57-192952 (= U.S. Pat. 4,467,027) and Sho 59-84241 (= U.S. Pat. 4,500,625).

After development, the plate may, if necessary, be subjected to a desensitization treatment after water washing; or directly subjected to a desensitization treatment without washing with water; or subjected to a treatment with an aqueous solution containing an acid; or further subjected to a desensitization treatment after the treatment with an aqueous solution containing an acid. Moreover, in such a process for developing a PS plate, the alkaline aqueous solution is consumed as the quantity of the PS plates processed increased and thus the concentration of the alkali is decreased or the alkali concentration is reduced due to the absorption of air during a long term operation of an automatic developing machine. In such case, a replenisher for the developer may be supplemented to regenerate the developing ability as disclosed in J.P. KOKAI No. Sho 54-62004(= U.S. Pat. 4,259,434).

As light sources used for the imagewise exposure of the light-sensitive layer, there may be mentioned, for instance, a carbon arc lamp, a mercury lamp, a xenon lamp, a tungsten lamp or a metal halide lamp.

As has been discussed above in detail, in the method for forming images according to the present invention, there is used an aqueous alkaline developer substantially free of organic solvents during development processing. Therefore, the method does not suffer from any problems, for instance, hygienic ones such as toxicity and giving out of bad smell during operations; problems concerning safety such as catching a fire and a gas explosion; and environmental pollution due to waste liquor. In addition, the method makes it possible to reduce the cost.

Moreover, when the method for forming images of the present invention is applied to formation of lithographic printing plates, negative-working PS plates can be developed with an aqueous alkaline developer which is known as a developer for positive-working PS plates. For this reason, when both positive- and negative-working PS plates are processed, the method makes it possible to save the operator's labor required for the preparation of different two kinds of developer compositions favorable for these PS plates respectively, exchange of the developer compositions, preliminary preparation of two kinds of developer compositions and apparatuses for development processing or the like. In other words, the method can substantially improve working efficiency and reduce the cost of equipment and space for arrangement thereof.

The present invention will hereinafter be explained in more detail with reference to the following non-limitative working Examples and the effects practically attained by the invention will also be discussed in detail in comparison with Comparative Examples.

Example 1

An aluminum plate was degreased with a 3% aqueous solution of sodium hydroxide, electrolytically etched at an electric current of 3 A/dm$^2$ and a temperature of 25 °C in a 2% hydrochloric acid bath, washed with water and then anodized at a current density of 1.5 A/dm$^2$ and a temperature of 30 °C for 2 minutes in a 15% sulfuric acid bath. Then the aluminum plate was subjected to sealing treatment at 85 °C for 30 seconds in a 1% sodium metasilicate aqueous solution, washed with water and dried to obtain an aluminum plate for PS plates. A light-sensitive solution having the following composition was applied onto the aluminum plate thus treated so that the weight of the resulting film was 1.5 g/m$^2$ (weighed after drying).

| Light-Sensitive Solution-1 | |
|---|---|
| Component | Amount (g) |
| Lypophilic polymeric compound-1 | 5.0 |
| Diazo co-condensed resin-1 (Preparation Example 1) | 0.6 |
| Victoria Pure Blue BOH (available from HODOGAYA CHEMICAL CO., LTD.) | 0.1 |
| JULYMER AC-10L (available from NIPPON JUNYAKU KK.) | 0.3 |
| Methyl cellosolve | 100(ml) |

The resulting PS plate was brought into close contact with a negative original transparency and a step wedge (whose optical density is stepwise increased by 0.150), exposed to light from a 2KW metal halide lamp at a distance of 60 cm for 30 seconds and developed with a developer having the following composition at 30° C for 40 seconds. Under such conditions, the time required for the step to reproduce 4th solid density was 18 seconds.

| Composition of Developer | |
|---|---|
| Component | Amount (g) |
| Sodium silicate having a molar ratio, $SiO_2/Na_2O$ of about 1.1 | 20 |
| Water | 1000 |

Thus, a good lithographic printing plate was obtained without causing insufficient development (cause of background contamination) in the non-image areas.

Then a half of the non-image areas of the resulting printing plate was again exposed to light and the result obtained was compared with that for the other half of the non-image areas in order to examine the amount of the diazo resin remaining on the non-image areas. As a result, any difference between them could not be visually detected at all. Moreover, the same PS plate was subjected to forced storage at 55° C and 80% RH for 3 days, then a lithographic printing plate was prepared as in the same manner as that described above and a good lithographic printing plate was obtained without causing any contamination.

The resulting printing plate was set on an offset printing press and printing operations were performed. As a result, a great deal of copied carrying sharp and high contrast images could be obtained.

Example 2

A light-sensitive solution having the following composition was applied onto the same aluminum plate used in Example 1 so that the weight of the resulting film was 1.5 g/m$^2$ (weighed after drying) to thus give a PS plate.

| Light-Sensitive Solution-2 | |
|---|---|
| Component | Amount (g) |
| Lypophilic polymeric compound-1 | 5.0 |
| Diazo co-condensed resin-2 (Preparation Example 2) | 0.6 |
| Victoria Pure Blue BOH (available from HODOGAYA CHEMICAL CO., LTD.) | 0.1 |
| JULYMER AC-10L (available from NIPPON JUNYAKU KK.) | 0.3 |
| Methyl cellosolve | 100(ml) |

The resulting PS plates were exposed to light under the same conditions used in Example 1 for 30

seconds and then developed with the same developer used in Example 1 at 25 °C for 40 seconds to thus give excellent lithographic printing plates substantially free of any background contamination. In this case, the exposure time required for the step to reproduce 4th solid density was 20 seconds. Then the quantity of the diazo resin remaining on the non-image areas was examined in the same manner as used in Example 1 and as a result, the difference could not be visually detected. In addition, the PS plate which had been subjected to forced storage was developed. The resulting lithographic printing plate had no background contamination and provided good copies.

Comparative Example 1

The same procedures used in Example 1 were repeated except that the diazo resin-1 as will be explained below was substituted for the diazo co-condensed resin-1 in the light-sensitive solution-1 used in Example 1. The diazo resin-1 was obtained by repeating the same procedures used in Preparation Example 1 except that 29.3 g (0.1 mole) of 4-diazodiphenylamine sulfate was substituted for p-hydroxybenzoic acid. In this case, the exposure time required for the step to reproduce 4th solid density was 25 seconds. The weight average molecular weight of the resulting 4-diazodiphenylamine • hexafluorophosphate-formaldehyde resin was determined by GPC and found to be about 2,300.

The PS plate exposed to light was developed with the foregoing developer and as a result, the resulting lithographic printing plate had background contamination on the non-image areas.

On the other hand, in order to examine the quantity of the diazo resin remaining on the non-image areas, a half of the non-image areas was again exposed to light and the result was compared with that for the other half which had not been subjected to post-exposure. As a result, the residual diazo resin was clearly observed on the non-postexposed areas.

Comparative Example 2

The same prccedures used in Example 2 were repeated except that the diazo resin-2 as would be explained below was substituted for the diazo co-condensed resin-2 in the light-sensitive solution-2 used in Example 2. The diazo resin-2 was obtained by repeating the same procedures used in Preparation Example 2 except that 29.3 g (0.1 mole) of 4-diazodiphenylamine sulfate was substituted for p-hydroxybenzoic acid. In this case, the exposure time required for the step to reproduce 4th solid density was 30 seconds. The weight average molecular weight of the resulting 4-diazodiphenylamine • hexafluorophosphate-formaldehyde resin was determined by GPC and found to be about 2, 300.

The PS plate exposed to light was developed with the foregoing developer and as a result, the resulting lithographic printing plate had background contamination on the non-image areas.

On the other hand, in order to examine the quantity of the diazo resin remaining on the non-image areas, a half of the non-image areas was again exposed to light and the result was compared with that for the other half which had not been subjected to post-exposure. As a result, the residual diazo resin was clearly observed on the non-postexposed areas.

Example 3

A light-sensitive solution having the following composition was applied onto the same aluminum plate used in Example 1 so that the weight of the resulting film was 1.7 g/m$^2$ (weighed after drying) to thus give a PS plate.

| Light-Sensitive Solution-3 | |
|---|---|
| Component | Amount (g) |
| Lypophilic polymeric compound-2 | 5.0 |
| Pyrogallol/4-diazo-4′-methoxydiphenylamine•hexafluorophosphate/formaldehyde resin (prepared in the same manner as in Preparation Example 1; weight average molecular weight: about 2,500) | 0.6 |
| Oil Blue #603 (available from ORIENT CHEMICAL CO., LTD.) | 0.2 |
| Methyl cellosolve | 100(ml) |

The resulting PS plates were exposed to light under the same conditions used in Example 1 for 40 seconds and then developed with the same developer used in Example 1 at 30 °C for 30 seconds to thus give excellent lithographic printing plates substantially free of any background contamination on the non-image areas. In this case, the exposure time required for the step to reproduce 4th solid density was 18 seconds. Then the quantity of the diazo resin remaining on the non-image areas was examined in the same manner as used in Example 1 and as a result, the difference could not be visually detected at all. In addition, the PS plate which had been subjected to forced storage was developed. The resulting lithographic printing plate had no background contamination and provided good copies.

Example 4

A light-sensitive solution having the following composition was applied onto the same aluminum plate used in Example 1 so that the weight of the resulting film was 1.7 g/$m^2$ (weighed after drying) to thus give a PS plate.

| Light-Sensitive Solution-4 | |
|---|---|
| Component | Amount (g) |
| Lypophilic polymeric compound-2 | 5.0 |
| Pyrogallol/4-diazodiphenylamine • 2-hydroxy-4-methoxybenzophenone-5-sulfonate/ formaldehyde resin (prepared in the same manner as in Preparation Example 2; weight average molecular weight: about 2,600) | 0.6 |
| Oil Blue #603 (available from ORIENT CHEMICAl CO., LTD.) | 0.2 |
| Methyl cellosolve | 100(ml) |

The resulting PS plates were exposed to light under the same conditions used in Example 1 for 40 seconds and then developed with the same developer used in Example 1 at 30 °C for 20 seconds to thus give excellent lithographic printing plates substantially free of any background contamination on the non-image areas. In this case, the exposure time required for the step to reproduce 4th solid density was 20 seconds. Then the quantity of the diazo resin remaining on the non-image areas was examined in the same manner as used in Example 1 and as a result, the difference could not be visually detected at all. In

addition, the PS plate which had been subjected to forced storage was developed. The resulting lithographic printing plate had no background contamination and provided good copies.

Example 5

An aluminum plate which had been degreased was subjected to a primary graining by the liquid honing method with an aqueous suspension of 400 mesh pumice stone, then the surfaoe thereof was slightly etched with a 10% sodium hydroxide solution and subjected to a secondary graining by electrolytic etching at a current density of 10 A/dm$^2$ and 30 °C in a 2% nitric acid bath. Thereafter, the plate was anodized and sealed in the same manner as in Example 1 to give an aluminum substrate for PS plates. A light-sensitive solution having the following composition was applied onto the aluminum plate thus treated so that the weight of the resulting layer was 1.5 g/m$^2$ (on dry basis).

| Light-Sensitive Solution-5 | |
|---|---|
| Component | Amount (g) |
| Lypophilic polymeric compound-3 | 5.0 |
| 2,4-Dihydroxybenzophenone-4-diazo-4′-methoxydiazodiphenylamine • hexafluorophosphate/formaldehyde resin (average molecular weight: 2,700) | 0.7 |
| Victoria Pure Blue BOH (available from HODOGAYA CHEMICAL CO., LTD.) | 0.1 |
| Methyl cellosolve | 100(ml) |

The resulting PS plates were exposed to light under the same conditions used in Example 1 for 40 seconds and then developed with the same developer used in Example 1 at 30 °C for 30 seconds to thus give excellent lithographic printing plates substantially free of any background contamination. In this case, the exposure time required for the step to reproduce 4th solid density was 20 seconds. Then the quantity of the diazo resin remaining on the non-image areas was examined in the same manner as used in Example 1 and as a result, the difference could not be visually detected. In addition, the PS plate which had been subjected to forced storage was developed. The resulting lithographic printing plate had no background contamination and provided good copies.

Example 6

A light-sensitive solution having the following composition was applied onto the same aluminum plate used in Example 5 so that the weight of the resulting layer was 1.5 g/m$^2$ (on dry basis).

| Light-Sensitive Solution-6 | |
|---|---|
| Component | Amount (g) |
| Lypophilic polymeric compound-3 | 5.0 |
| 2,4-Dihydroxybenzophenone-4-diazo-4′-methyldiazodiphenylamine • dibutylnaphthalenesulfonate/formaldehyde resin (average molecular weight: 2,400) | 0.7 |
| Victoria Pure Blue BOH (available from HODOGAYA CHEMICAL CO., LTD.) | 0.1 |
| Methyl cellosolve | 100(ml) |

The resulting PS plates were exposed to light under the same conditions used in Example 1 for 40 seconds and then developed with the same developer used in Example 1 at 30 °C for 20 seconds to thus

give excellent lithographic printing plates substantially free of any background contamination. In this case, the exposure time required for the step to reproduce 4th solid density was 18 seconds. Then the quantity of the diazo resin remaining on the non-image area was examined in the same manner as used in Example 1 and as a result, the difference could not be visually detected. In addition, the PS plate which had been subjected to forced storage was developed. The resulting lithographic printing plate had no background contamination and provided good copies.

Example 7

A PS plate was prepared by repeating the same procedures as used in Example 1 except that the diazo co-condensed resin-3 was substituted for the diazo co-condensed resin-1 in the light-sensitive solution-1 used in Example 1.

The resulting PS plate was brought into close contact with a negative original transparency and a step wedge (whose optical density is stepwise increased by 0.150), exposed to light from a 2KW metal halide lamp at a distance of 60 cm for 30 seconds and developed with the same developer as used in Example 1 at 30 ° C for 40 seconds. Under such conditions, the time required for the step to reproduce 4th solid density was 16 seconds.

Thus, a good lithographic printing plate was obtained without causing insufficient development (cause of background contamination) in the non-image areas.

Then a half of the non-image areas of the resulting printing plate was again exposed to light and the result obtained was compared with that for the other half of the non-image areas in order to examine the amount of the diazo resin remaining on the non-image areas. As a result, any difference between them could not be visually detected at all. Moreover, the same PS plate was subjected to forced storage at 55 ° C and 80% RH for 3 days, then a lithographic printing plate was prepared as in the same manner as that described above and a good lithographic printing plate was obtained without causing any contamination.

The resulting printing plate was set on an offset printing press and printing operations were performed. As a result, a great deal of copied carrying sharp and high contrast images could be obtained.

## Claims

1. A method for forming images which comprises the steps of, in order, imagewise exposing to light a light-sensitive material comprising a support having thereon a light-sensitive layer containing a light-sensitive co-condensed diazo resin having a structural unit derived from an aromatic compound having at least one of carboxyl and hydroxyl groups and a structural unit derived from an aromatic diazonium compound to form light-exposed and light-unexposed areas in the light-sensitive layer, and developing the light-sensitive material with an aqueous alkaline developer substantially free from an organic solvent to remove the light-unexposed areas of the light-sensitive layer.

2. The method of claim 1, wherein said aromatic diazonium compound is a compound represented by the following general formula (I):

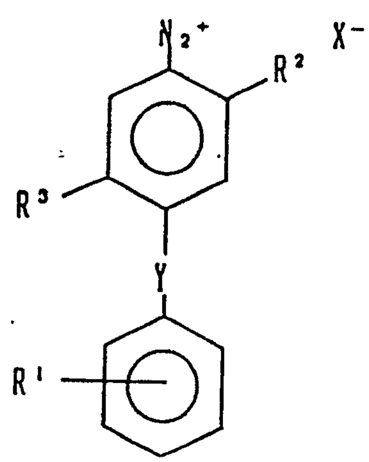

(I)

wherein $R^1$ represents hydrogen atom, a substituted or unsubstituted alkyl group, an alkoxy group, hydroxyl group, a carboxyl ester group, a carboxyl group; $R^2$ and $R^3$, which may be the same or different to each other, each represents hydrogen atom, an alkyl group or an alkoxy group; $X^-$ represents an anion; and Y represents -NH-, -O- or -S-.

3. The method of claim 2, wherein $R^1$ represents hydrogen atom, an alkyl group having 1 to 5 carbon atoms, an alkoxy group shaving 1 to 4 carbon atoms or hydroxyl group; $R^2$ represents hydrogen atom or alkoxy group having 1 to is carbon atoms; $R^3$ represents hydrogen atom; $X^-$ represents an anion derived from an inorganic or organic acid having a pKa value of not more than is; and Y represents -NH-.

4. The method of claim 2 wherein the aromatic diazonium compound represented by the general formula (I) is a member selected from the group consisting of salts of 4-diazodiphenylamine, 4′-hydroxy-4-diazodiphenylamine, 4′-methyl-4-diazodiphenylamine, 4′-ethyl-4-diazodiphenylamine, 4′-n-propyl-4-diazodiphenylamine, 4′-i-propyl-4-diazodiphenylamine, 4′-n-butyl-4-diazodiphenylamine, 4′-hydroxymethyl-4-diazodiphenylamine, 4′-β-hydroxyethyl-4-diazodiphenylamine, 4′-γ-hydroxypropyl-4-diazodiphenylamine, 4′-methoxymethyl-4-diazodiphenylamine, 4′-ethoxymethyl-4-diazodiphenylamine, 4′-β-methoxyethyl-4-diazodiphenylamine, 4′-β-ethoxyethyl-4-diazodiphenylamine, 4′-carboxyl-4-diazodiphenylamine, 3-methyl-4-diazodiphenylamine, 3-ethyl-4-diazodiphenylamine, 3′-methyl-4-diazodiphenylamine, 3,3′-dimethyl-4-diazodiphenylamine, 2′-carboxyl-4-diazodiphenylamine, 4-diazodiphenyl ether, 4′-methyl-4-diazodiphenyl ether, 3,4′-dimethyl-4-diazodiphenyl ether, 4′-carboxyl-4-diazodiphenyl ether, 3,3′-dimethyl-4- diazodiphenyl ether, 4-diazodiphenyl sulfide and 4′-methyl-4-diazodiphenyl sulfide.

5. The method of claim 3, wherein said aromatic diazonium compound is one selected from the group consisting of salts of 4-diazodiphenylamine, 4-diazo-4′-methoxydiphenylamine, 4-diazo-4′-methoxydiphenylamine and 4-diazo-3-methoxydiphenylamine.

6. The method of claim 1 wherein the aromatic compound having at least one of carboxyl and hydroxyl groups is an aromatic compound comprising an aromatic ring structure substituted with at least one carboxyl group and/or an aromatic ring structure substituted with at least one hydroxyl group in the molecule.

7. The method of claim 6 wherein the aromatic ring structure is benzene or naphthalene.

8. The method of claim 1 wherein the aromatic compound having at least one of carboxyl and hydroxyl groups is at least one member selected from the group consisting of salicylic acid, 4-methylsalicylic acid, 6-methylsalicylic acid, 4-ethylsalicylic acid, 6-propylsalicylic acid, 6-laurylsalicylic acid, 6-stearylsalicylic acid, 4,6-dimethylsalicylic acid, p-hydroxybenzoic acid, 2-methyl-4-hydroxybenzoic acid, 6-methyl-4-hydroxybenzoic acid, 2,6-dimethyl-4-hydroxybenzoic acid, 2,4-dihydroxybenzoic acid, 2,4-dihydroxy-6-methylbenzoic acid, 2,6-dihydroxybenzoic acid, 2,6-dihydroxy-4-benzoic acid, 4-chloro-2, 6-dihydroxybenzoic acid, 4-methoxy-2,6-dihydroxybenzoic acid, gallic acid, fluoroglucincarboxylic acid, 2,4,5- trihydroxybenzoic acid, m-galloylgallic acid, tannic acid, m-benzoylgallic acid, m-(p-toluyl)gallic acid, protocatechuoylgallic acid, 4,6-dihydroxyphthalic acid, (2,4-dihydroxyphenyl) acetic acid, (2,6-dihydroxyphenyl)acetic acid, (3,4,5-trihydroxyphenyl)acetic acid, p-hydroxymethyl benzoic acid, p-hydroxyethyl benzoic acid, 4-(p-hydroxyphenyl)-methyl benzoic acid, 4-(p-hydroxyphenoxy)benzoic acid, 4-(p-hydroxyanilino) benzoic acid, bis(3-carboxy-4-hydroxyphenyl)amine, 4-(p-hydroxyphenylsulfonyl)benzoic acid, 4-(p-hydroxyphenylthio) benzoic acid, p-methoxybenzoic acid, 2,4-dimethoxybenzoic acid, 2,4-dimethylbenzoic acid, p-phenoxybenzoic acid, p-methoxyphenyl acetic acid, phenoxyacetic acid, 4-anilinobenzoic acid, 4-(m-methoxyanilino)benzoic acid, 4-(p-methoxybenzoyl) benzoic acid, 4-(p-methylanilino)benzoic acid, 4-phenylsulfonylbenzoic acid, phenol, o-, m- or p-cresol, xylenol, resorcin, 2-methylresorcin, o-, m- or p-methoxyphenol, m-ethoxyphenol, catechol, fluoroglucin, p-hydroxyethylphenol, naphthol, pyrogallol, hydroquinone, p-hydroxybenzyl alcohol, 4-chlororesorcin, biphenyl-4,4′-diol, 1,2,4-benzenetriol, bisphenol A, 2,4-dihydroxybenzophenone, 2,3,4-trihydroxybenzophenone, p-hydroxyacetophenone, 4,4′-dihydroxydiphenyl ether, 4,4′-dihydroxydiphenylamine, 4,4′-dihydroxysulfone, 4,4′-dihydroxydiphenyl sulfide and cumylphenol.

9. The method of claim 8 wherein the aromatic compound having at least one of carboxyl and hydroxyl groups is at least one member selected from the group consisting of salicylic acid, p-hydroxybenzoic acid, 2,4-dihydroxybenzoic acid, gallic acid, fluoroglucincarboxylic acid, 4-(p-hydroxyanilino)benzoic acid, 2,4-dimethoxybenzoic acid, p-phenoxybenzoic acid, 4-anilinobenzoic acid, 4-(m-methoxyanilino)benzoic acid, 4-(p-methylanilino)benzoic acid, p-cresol, resorcin, 2-methylresorcin, pyrogallol, p-methoxyphenol, 4,4′-dihydroxydiphenyl ether, 4,4′-dihydroxydiphenylamine and 2,3,4-trihydroxybenzophenone.

10. The method of claim 1 wherein the light-sensitive co-condensed resin having the structural unit derived from the aromatic compound having at least one of carboxyl and hydroxy groups and the structural unit derived from the aromatic diazonium compound is one prepared by polycondensing a diazonium salt, an aromatic compound having carboxyl and/or hydroxyl groups and an aldehyde or a ketone in a sulfuric acid, phosphoric acid or hydrochloric acid solution.

11. The method of claim 10 wherein the ratio of the aromatic compound having carboxyl and/or hydroxyl groups to the aromatic diazonium compound ranges from 1:0.1 to 0.1:1 and the ratio of the total amount of the aromatic compound carrying carboxyl and/or hydroxyl groups and the aromatic diazo compound to that of the aldehyde or ketone ranges from 1:0.6 to 1.5.

12. The method of claim 1 wherein the co-condensed diazo resin is a member selected from the group consisting of salicylic acid-4-diazo-4′-methoxydiphenylamine • hexafluorophosphate-formaldehyde resin, p-hydroxybenzoic acid-4-diazo-4′-methoxydiphenylamine • hexafluorophosphate-formaldehyde resin, 2,4-dihydroxybenzoic acid-4-diazo-4′-methoxydiphenylamine • hexafluorophosphate-formaldehyde resin, resorcin-4-diazo-4′-methoxydiphenyl-amine • hexafluorophosphate-formaldehyde resin, pyrogallol-4-diazo-4′-methoxydiphenylamine • hexafluorophosphate-formaldehyde resin, 2,4-dihydroxybenzophenone-4-diazo-4′-methoxydiphenylamine • hexafluorophosphate-formaldehyde resin, salicylic acid-4-diazodiphenylamine • 2-hydroxy-4-methoxybenzophenone-5-sulfonate-formaldehyde resin, p-hydroxybenzoic acid-4-diazodiphenylamine • hexafluorophosphate-formaldehyde resin, phenoxyacetic acid-4-diazodiphenylamine • hexafluorophosphate-formaldehyde resin, phenoxyacetic acid-is-diazodiphenylamine • dodecylbenzene-sulfonate-formaldehyde resin, 2,4-dihydroxybenzoic acid-4-diazodiphenylamine • 2-hydroxy-4-methoxybenzophenone-5-sulfonate-formaldehyde resin, resorcin-diazodiphenylamine • methanesulfonate-formaldehyde resin, pyrohallol-4-4-diazo-4′-methyldiphenylamine • hexafluorophosphate-formaldehyde resin and 2,4-dihydroxybenzophenone-4-diazodiphenylamine • dibutylnaphthalenesulfonate-formaldehyde resin.

13. The method of claim 1 wherein the molecular weight of the co-condensed diazo resin ranges from about 800 to 5,000.

14. The method of claim 1 wherein the anion is a member selected from the group consisting of those derived from hexafluorophosphoric acid, methanesulfonic acid, dibutylnaphthalenesulfonic acid, 2-methoxy-4-hydroxy-5-benzoylbenzenesulfonic acid and 2-hydroxy-4-methoxybenzophenone -5-sulfonic acid.

15. The method of claim 1 wherein the co-condensed diazo resin is used in combination with an alkali-Soluble or alkali-swellable lypophilic polymeric compound having a carboxyl value ranging from 0 to 3 meq/g and a molecular weight ranging from 10,000 to 150,000.

16. The method of claim 16 wherein the amount of the co-condensed diazo resin ranges from 3 to 30% by weight and that of the lypophilic polymeric compound ranges from 50 to 95% by weight on the basis of the solid contents of the light-sensitive layer.

17. The method of claim 1 wherein the light-sensitive layer further comprises a dye whose color tone is changed through a reaction with a free radical or an acid.

18. The method of claim 18 wherein the amount of the dye ranges from about 1 to 5% by weight on the basis of the total weight of the light-sensitive layer.

19. The method of claim 1 wherein the light-sensitive layer further comprises a surfactant, a plasticizer, an agent for improving ink receptivity of an image and/or a stabilizer in an amount ranging from 0.01 to 30% by weight on the basis of the total weight of the light-sensitive layer.

20. The method of claim 1, wherein the developer comprises an alkaline agent selected from the group consisting of sodium silicate, potassium silicate, potassium hydroxide and sodium hydroxide, and water.

21. The method of claim 20, wherein the developer further comprises an anionic surfactant in an amount of from 0.1 to 5% by weight based on the total weight of the developer.